Europäisches Patentamt

European Patent Office

Office européen des brevets

(19)

(11) EP 0 439 164 B1

(12) **EUROPEAN PATENT SPECIFICATION**

(45) Date of publication and mention
of the grant of the patent:
**17.07.1996 Bulletin 1996/29**

(51) Int Cl.⁶: **H01L 29/772**, H01L 29/41

(21) Application number: **91100892.8**

(22) Date of filing: **24.01.1991**

(54) **Field-effect transistor having a vertical structure and method of manufacturing the same**

Feldeffekttransistor mit vertikaler Struktur und Verfahren zur Herstellung

Transistor à effet de champ à structure verticale et sa méthode de fabrication

(84) Designated Contracting States:
**DE FR GB**

(30) Priority: **25.01.1990 JP 13525/90**

(43) Date of publication of application:
**31.07.1991 Bulletin 1991/31**

(73) Proprietor: **KABUSHIKI KAISHA TOSHIBA**
**Kawasaki-shi, Kanagawa-ken 210 (JP)**

(72) Inventor: **Mizuno, Tomohisa,**
**c/o Intellectual Property Div.**
**Minato-ku, Tokyo 105 (JP)**

(74) Representative: **Lehn, Werner, Dipl.-Ing. et al**
**Hoffmann, Eitle & Partner,**
**Patentanwälte,**
**Postfach 81 04 20**
**81904 München (DE)**

(56) References cited:
**EP-A- 0 284 065**

- **PATENT ABSTRACTS OF JAPAN vol. 12, no. 322 (E-652)31August 1988 &JP-A-63 086 478 ( MITSUBISHI ELECTRIC CORP. ) 16 April 1988**
- **PATENT ABSTRACTS OF JAPAN vol. 14, no. 161 (E-909)28March 1990 & JP-A-2 017 675**
- **PATENT ABSTRACTS OF JAPAN vol. 13, no. 359 (E-804)10August 1989 &JP-A-1 119 055 ( SONY CORP. ) 11 May 1989**

## Description

The present invention relates to a semiconductor device and a method of manufacturing the same and, more particularly, a semiconductor device including a MOS transistor in which a recess portion or a convex portion is formed on a substrate and a gate electrode is formed on the side walls of the portions to increase a surface integration density.

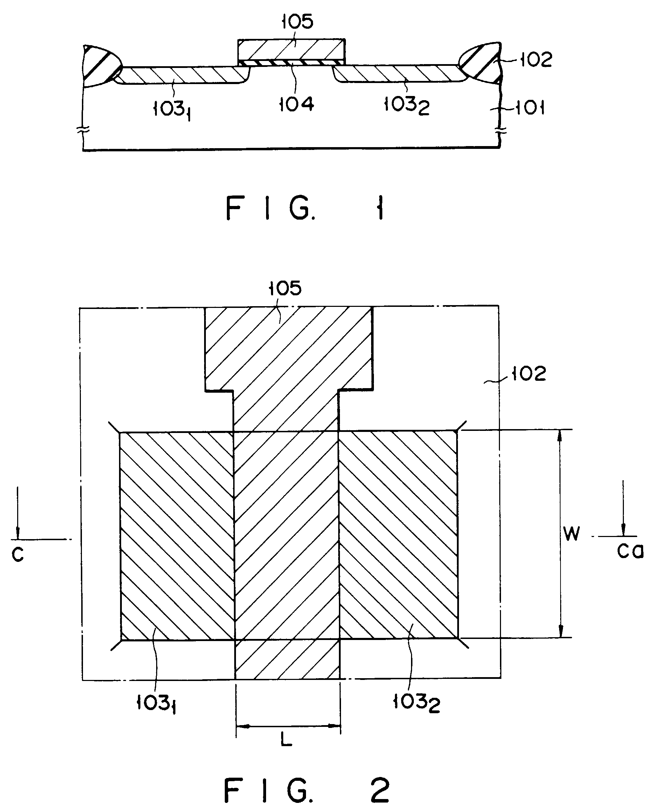

A structure of a conventional MOS transistor is shown in Figs. 1 and 2.

Fig. 1 is a sectional view showing a conventional MOS transistor, and Fig. 2 is a plan view showing the MOS transistor taken along a line D - Da in Fig. 1. As shown in Fig. 1 (for example, a MOS transistor in Fig. 1 is an n-channel transistor), an element isolation region 102 is formed on the surface of a p-type substrate 101, and n-type source/drain regions $103_1$ and $103_2$ are formed in an element region isolated by the element isolation region 102. A gate insulating film 104 is formed in a channel region formed between the source/drain regions $103_1$ and $103_2$. A gate electrode 105 is formed thereon.

In the MOS transistor shown in the plan view of Fig. 2, the source/drain regions $103_1$ and $103_2$ are formed on both the sides of the gate electrode 105. In this case, a width L of the gate electrode 105 is a channel length, and a width W of the source/drain regions 103 in a direction perpendicular to the channel length direction is channel width.

under a condition $V_d > V_G - V_T$, a current drivability $I_d$ of the MOS transistor having the above structure is given by the following equation:

$$I_d = (W/2L) \times \mu C_{OX}(V_G - V_T)^2 \qquad (1)$$

where L is a channel length, W is a channel width, $\mu$ is mobility, $C_{OX}$ is a gate insulating film capacitance, and $V_d$, $V_G$, and $V_T$ are a drain voltage, a gate voltage, a gate threshold voltage, respectively.

At present, in order to obtain a high-output MOS transistor requiring a large current drivability $I_d$, as is apparent from equation (1), in many cases, the gate width W is increased to improve the current drivability $I_d$. However, when the method of improving the current drivability $I_d$ is performed, an element surface area is increased in correspondence with an increase in gate width W, thereby disabling micropatterning of an element.

The above conventional technique is disclosed in a reference literature (1) T. Mizuno et al., Symp. VLSI Tech, Dig., P. 23 (1988). JP-A-63086478 of EP-A-0284065 show features corresponding to those of the preamble of claim 1.

The present invention has been made in consideration of the above problem and has as its object to provide a semiconductor device and a method of manufacturing the same including a high-output FET capable of increasing a channel width per element area of an FET to improve current drivability and increasing an integration density.

According to the present invention, there is provided a semiconductor device as set out in claim 1.

According to another aspect of the present invention, there is provided a method of manufacturing a semiconductor device as set out in claim 15

etching the second insulating film to be left in a predetermined amount so as to conform a side wall shape along the side surface, thereby covering the first conductive film,

etching a semiconductor constituting the first and second major surfaces by a predetermined amount using the second insulating film as a mask from the first and second major surfaces which are exposed by etching the second insulating film to form at least two first and second grooves,

doping a second impurity of a conductivity type opposite to that of the substrate in the first and second grooves using the second insulating film as a mask, forming a second conductive film on the entire surface, and

etching the second conductive film to expose the second insulating film so as to be left in the first and second grooves, thereby forming a wiring.

In the above semiconductor device, a cylindrical region having a curved surface is formed on a semiconductor substrate, a channel region is formed along the side surface of the cylindrical region, thereby forming an FET including a gate electrode having a curved portion. Therefore, since a channel width per element surface area is increased and the cylindrical region is curved, the surface area can be effectively utilized, and the channel width is further increased.

A spiral- or zigzag-shaped cylindrical region is practically used as the cylindrical region having the curved portion.

When the spiral- or zigzag-shaped cylindrical region is used, the cylindrical region is curved to obtain opposite portions. In this case, when an interval between the opposite portions is represented by $\underline{d}$ and a thickness of the gate electrode is represented by T, the following condition:

$$d > 2T$$

This invention can be more fully understood from the following detailed description when taken in conjunction with the accompanying drawings, in which:

Fig. 1 is a sectional view showing a conventional MOS transistor;
Fig. 2 is a plan view showing the MOS transistor showing in Fig. 1;
Figs. 3A to 3I are sectional views showing an FET included in a semiconductor device according to the first embodiment of the present invention in the order of manufacturing steps;

Figs. 4A to 4E are plan views showing an FET including the section of Figs. 3A to 3I in a position indicated by a line A - Aa';

Figs. 5A to 5I are plan views showing an FET included in a semiconductor device according to the second embodiment of the present invention;

Figs. 6A to 6E are plan views showing an FET including the section of Figs. 5A to 5I in a position indicated by a line B - Ba;

Figs. 7A to 7B are plan views showing a part of an FET included in a semiconductor device according to the third embodiment of the present invention; and

Figs. 8A and 8B are plan views showing a part of an FET included in a semiconductor device according to the fourth embodiment of the present invention.

A semiconductor device according to embodiments of the present invention will be described below together with a method of manufacturing the semiconductor device with reference to the accompanying drawings.

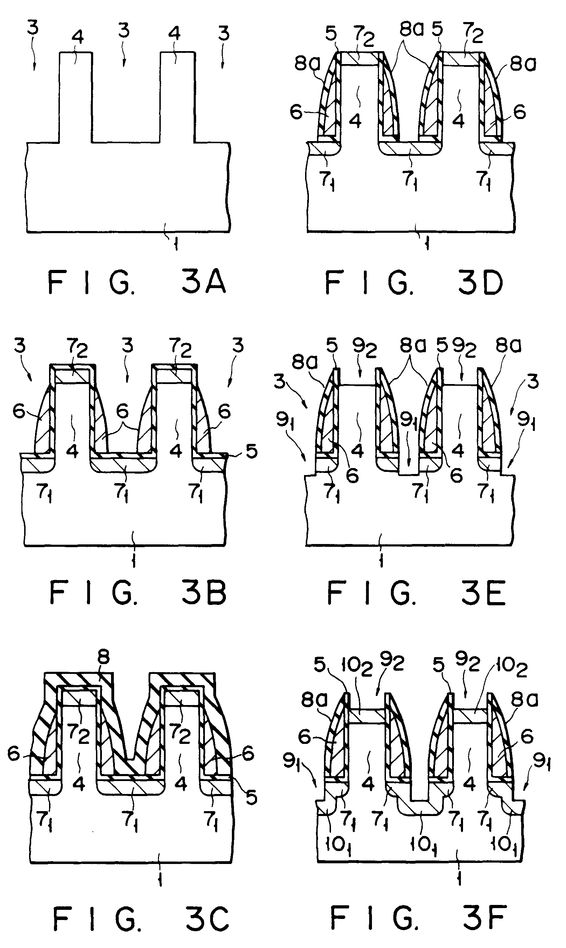

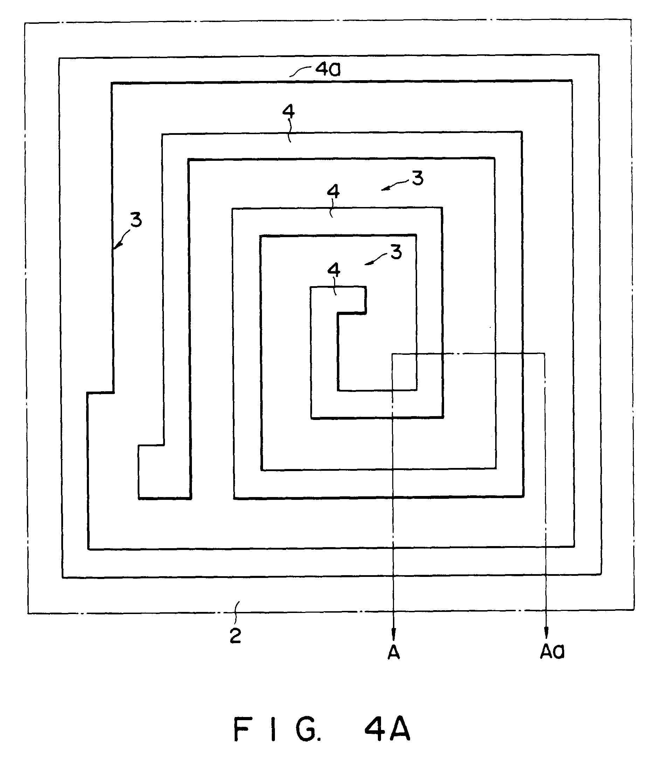

Figs. 3A to 3I are sectional views showing a MOS transistor included in a device according to the first embodiment of the present invention in the order of manufacturing steps, and Figs. 4A to 4E are plan views showing the transistor in the order of manufacturing steps. Figs. 3A to 3I are sectional views showing the MOS transistor taken along a line A - Aa in the plan views of Figs. 4A to 4E.

As shown in Figs. 3A and 4A, a field oxide film 2 is formed on, e.g., a p-type silicon substrate by, e.g., a LOCOS method. A photoresist is coated on the entire surface of the resultant structure and patterned, and then the substrate is selectively etched by an RIE method to form a first groove 3 in a substrate 1. At this time, when the first groove 3 is formed to have a spiral-shape, a spiral shaped cylindrical region 4 is formed. Note that the cylindrical region 4 has a height of 1 μm and a width of 2 μm. Reference numeral 4a in Fig. 4A denotes a flat portion of the substrate 1 surrounded by the field oxide film 2.

At this time, as shown in a plan view of Fig. 4A, for example, the cylindrical region 4 is formed to be separated from the flat portion 4a of the substrate 1 by the first groove 3 and to have an island shape.

The spiral-shaped cylindrical region 4 need not to be separated from the surface portion 4A but may be formed to be connected to the surface portion 4A.

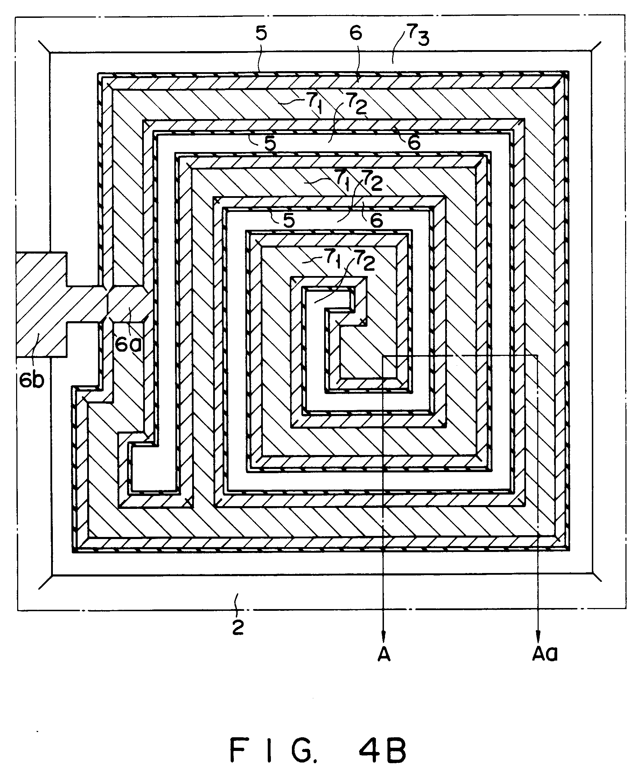

As shown in Figs. 3B and 4B, a gate insulating film 5 is formed on the entire surface of the resultant structure by, e.g., a thermal oxidation method in an HCℓ atmosphere at a temperature of 800°C to have a thickness of 100 Å. A polysilicon layer is deposited on the entire surface by, e.g., a CVD method to have a thickness having, e.g., 1/2 or less the width of the first groove 3.

Before a polysilicon layer is etched by an RIE method, a mask such as a photoresist is formed in a region serving as a wiring region for connecting a polysilicon layer located on the side surface of the cylindrical region 4 to a region serving as a gate contact portion shown in Fig. 4B in advance.

The polysilicon layer is etched by the RIE method to leave the polysilicon layer on the side surface of the cylindrical region 4 to have a maximum thickness of 3,000 Å in a horizontal direction. The etched polysilicon layer by the RIE method is represented by the reference numeral 6. The polysilicon layer is etched by the RIE method to form a gate contact region 6b and a wiring region 6a. When the polysilicon layer is etched, the polysilicon layer is over-etched. For this reason, the gate insulating film 5 is exposed on the upper surface of the cylindrical region 4, and the upper portion of the side of the cylindrical region 4 is exposed to have a length of 2,000 Å. In addition, the gate insulating film 5 is exposed at the center of the bottom portion of the first groove 3. The gate insulating film 5 is exposed on the flat portion 4a of the substrate 1. An n-type impurity such as arsenic is ion-implanted in the cylindrical region 4 and the substrate 1 through the gate insulating film 5 using the polysilicon layer 6 as a mask at an acceleration voltage of 40 keV and an impurity dose of $50 \times 10^{15}/cm^2$ to form $n^+$-type impurity layers $7_1$ to $7_3$. The polysilicon layer 6 is ion-implanted to be a gate electrode.

As shown in Fig. 3C, a CVD oxide film 8 is formed on the entire surface by, e.g., a CVD method to have a thickness of 2,000 to 3,000 Å.

As shown in Fig. 3D, the CVD oxide film 8 and the gate insulating film 5 are etched by an RIE method to expose the impurity region $7_2$ of the upper surface portion of the cylindrical region 4, the impurity region $7_3$, and a part of the impurity region $7_1$ of the bottom portion of the first groove 3. When the CVD oxide film is etched, only the polysilicon layer 6 is covered with a CVD oxide film 8a.

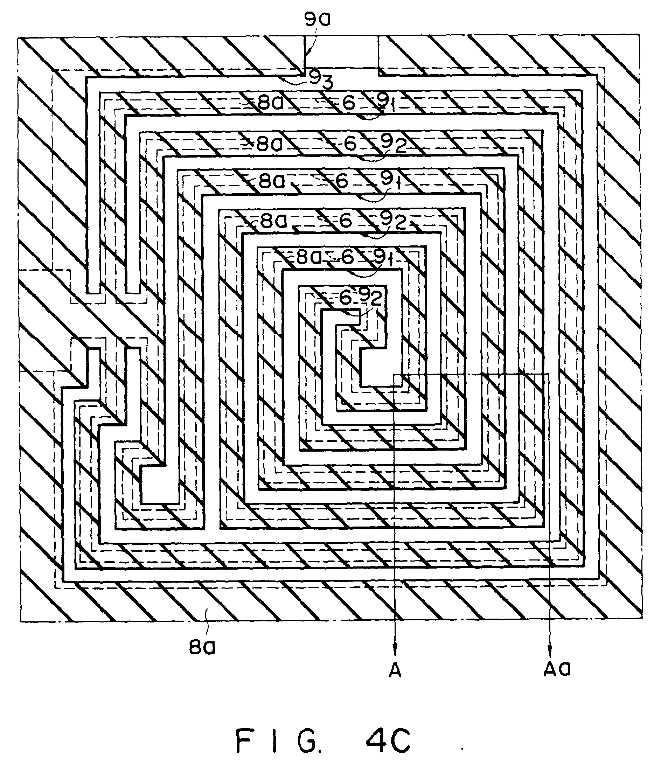

As shown in Figs. 3E and 4C, the impurity region $7_2$ of the upper surface portion of the cylindrical region 4, the part of the impurity region $7_1$ of the bottom portion of the first groove 3, and the impurity region $7_3$ of the flat portion 4a of the substrate 1, all of which are exposed by the etching process for the CVD oxide film 8, are etched to form a second groove $9_1$, a third groove $9_2$ and a fourth groove $9_3$. Note that, in the etching process, regions except for the fourth groove $9_3$ formation region of the flat portion 4a of the substrate 1 are covered with a photoresist film.

As shown in Fig. 3F, arsenic is ion-implanted in the second, third, and fourth grooves $9_1$, $9_2$, and $9_3$ at an acceleration voltage of 40 keV and an impurity dose of $5 \times 10^{15}/cm^2$. After the ion implantation, the arsenic ions implanted in the third groove are activated in an $N_2$ gas atmosphere at a temperature of 850°C for 20 minutes. As a result, an $n^+$-type source/drain diffusion layers $10_1$ and $10_2$ are formed. Note that an $n^+$-type source/

drain diffusion layer $10_3$ (not shown) is formed on the bottom of the fourth groove $9_3$ shown in Fig. 4C. At this time, the source/drain diffusion layer $10_1$ is formed to be integrated with the n+-type impurity layer $7_1$

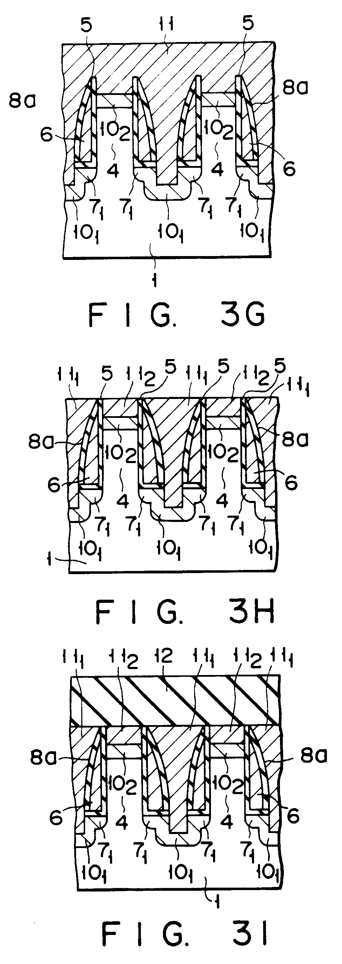

As shown in Fig. 3G, an aluminum film 11 serving as a wiring layer is deposited on the entire surface by a sputtering method to have a thickness of several μm or more.

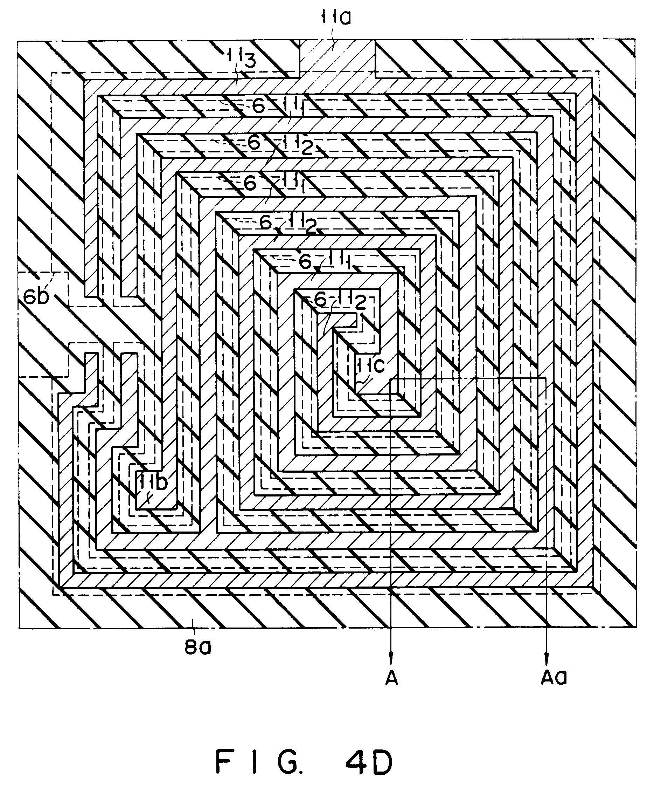

As shown in Figs. 3H and 4D, the aluminum film 11 is etched from the surface of the aluminum film 11 to the upper end portion of the gate insulating film 5 by the RIE method. The aluminum film 11 is left in only the second, third, and fourth grooves $9_1$, $9_2$, and $9_3$. As a result, a source/drain wiring is formed to be self-aligned. The aluminum films buried in the second, third, and fourth grooves $9_2$, $9_3$, and $9_4$ are represented by the reference numerals $11_1$, $11_2$, and $11_3$.

In a conventional field effect transistor, after an insulating interlayer is formed in source/drain regions, contacts is formed. Thereafter, an aluminum film for a source/drain wiring is formed, and then the aluminum film must be patterned.

In a field effect transistor having a MOS structure according to the present invention, a contact formation process and a patterning process can be omitted.

In Fig. 4D, regions represented by 11a to 11c serves as contact portions.

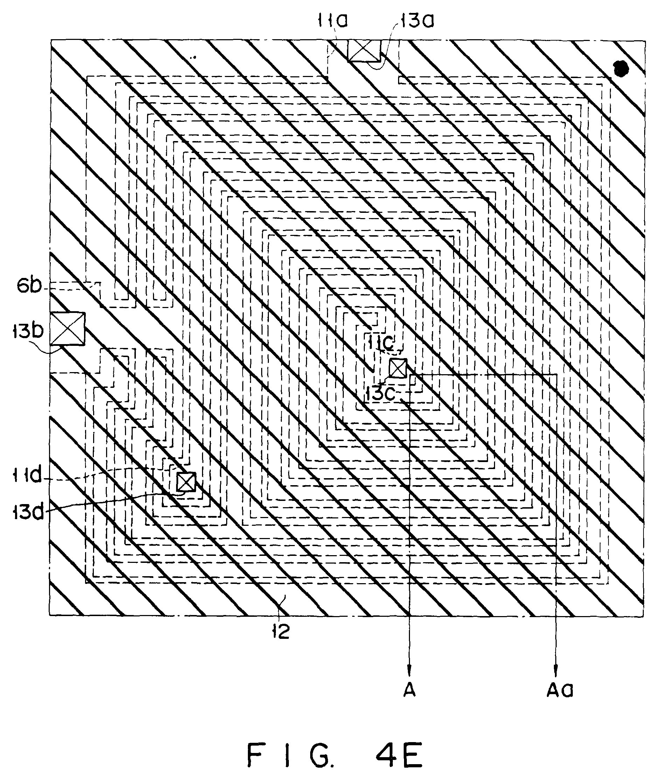

As shown in Figs. 2I and 4E, an insulating inter-layer 12 is deposited on the entire surface, and a photoresist film is coated on the entire surface and patterned. Thereafter, contact holes 13a, 13b, and 13c reaching the contact portions 6b and 11a to 11c are formed by, e. g., a photoetching method.

With the above processes, a MOS field effect transistor included in a device according to the first embodiment is formed.

According to the MOS field effect transistor, a cylindrical region is formed to have a spiral shape, a channel region is formed along the side surface of the cylindrical region 4, and a gate electrode is formed on the side surface of the cylindrical region 4. Therefore, a channel width per element surface area is increased.

Thus, a MOS transistor having high drivability can be obtained.

According to a method of manufacturing the MOS transistor, since a wiring for the source/drain diffusion layers $10_1$, $10_2$, and $10_3$ can be formed such that conductive layers are buried in the second, third, and fourth grooves $9_1$, $9_2$, and $9_3$ obtained by etching silicon, elements can be advantageously micropatterned.

When the thickness of the gate electrode 6 in a horizontal direction is set to be T and a width between the cylindrical regions is set to be $\underline{d}$, the condition can be given by:

$$d > 2T$$

With this setting, as shown in Figs. 3B and 4B, opposite portions of the cylindrical regions 4 formed by curving the cylindrical region 4 are not completely buried by the gate electrode 6, and the diffusion layer $7_1$ or the source/drain diffusion layer $10_1$ shown in Fig. 3F can be formed on the bottom surface between the cylindrical regions.

In addition, when a width of a gate depletion layer is set to be xj and a width of the cylindrical region 4 is set to be $\underline{b}$, and only when a condition of

$$b \leq 2xj$$

is satisfied, as in the reference literature described above, high drivability can be obtained by a gate bias. As a result, a high-output MOS transistor having a small element surface area and large-current drivability can be obtained.

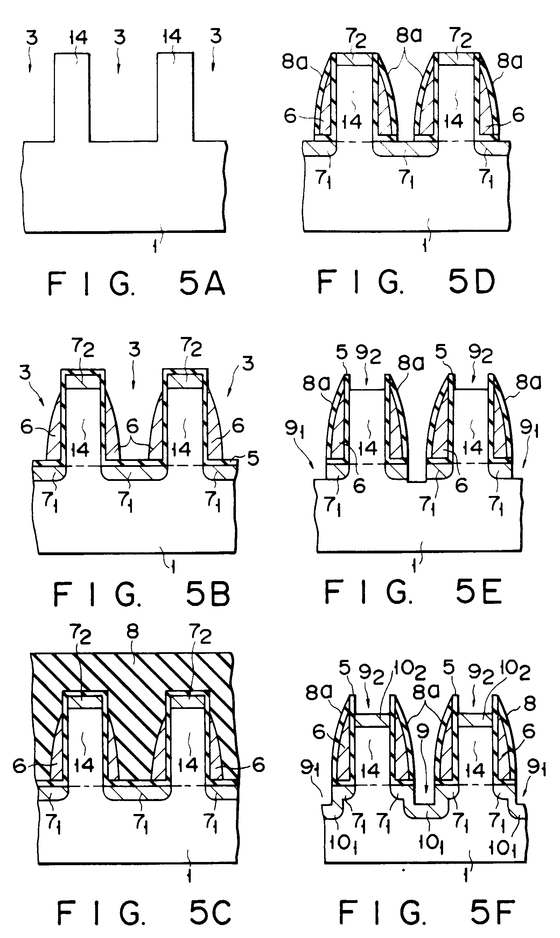

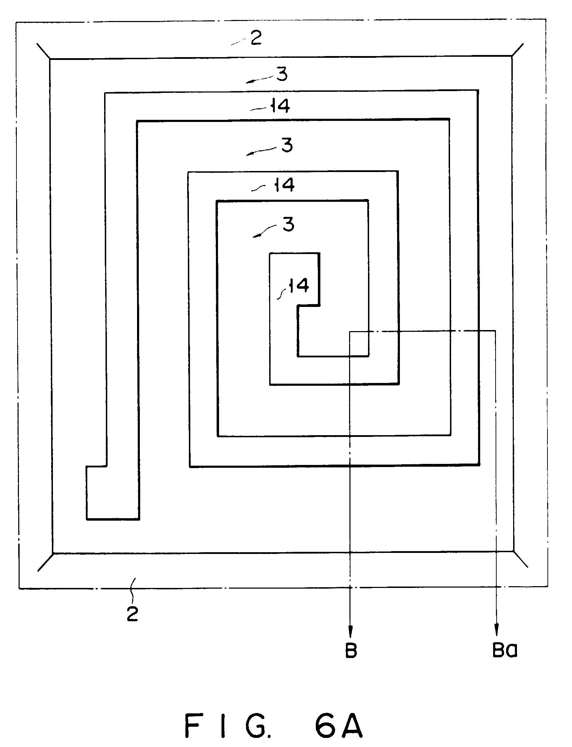

A semiconductor device according to the second embodiment of the present invention will be described below with reference to Figs. 5A to 5I and Figs. 6A to 6E.

Figs. 5A to 5I are sectional views showing a MOS field effect transistor included in the second embodiment of the present invention in the order of manufacturing steps, and Figs. 6A to 6E are plan views showing the MOS field effect transistor in the manufacturing steps. The section in Figs. 5A to 5I is taken along a line B - Ba in Figs. 6A to 6E.

Reference numerals in Figs. 5A to 5I and Figs. 6A to 6E denote the same parts as in Figs. 3A to 3I and Figs. 4A to 4E, respectively.

As shown in Figs. 5A and 6A, as in the first embodiment, after a field oxide film 2 is formed on a p-type silicon substrate 1, a spiral-shaped cylindrical region 14 is formed to project from the substrate 1 by selective epitaxial growth (SEG). The cylindrical region 14 has the same conductivity type as that of the substrate 1, i.e., a p-type.

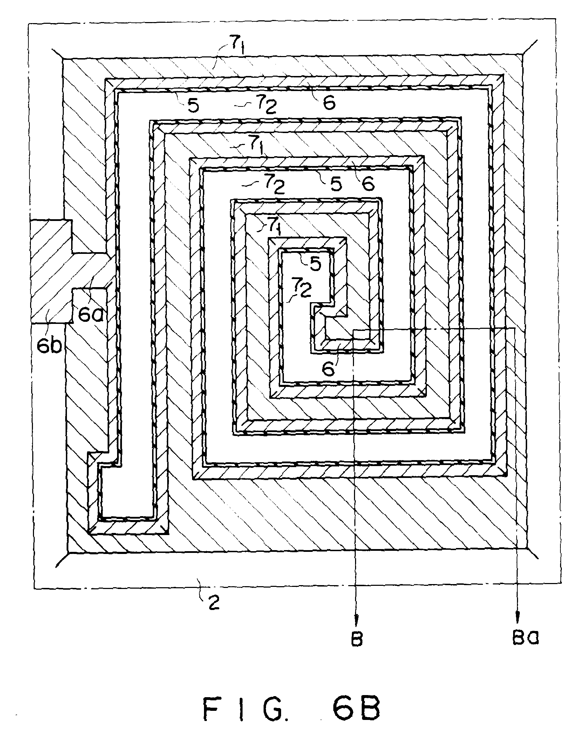

The above step described in Figs. 3B and 4B may be the same as that shown in Figs. 5B and 6B.

In this case, as shown in a plan view in Fig. 6B, when a polysilicon layer is etched by an RIE method to form a gate electrode 6, a mask such as a photoresist is formed in a prospective gate contact region and a prospective wiring region in advance. As shown in Fig. 6B, a region 6b to be contact portion and a wiring region 6a extending from the region 6b to the gate electrode 6 are formed.

The above step described in Figs. 3C and 3D may be the same as that shown in Figs. 5C and 5D.

When a CVD oxide film 8 is etched by an RIE method, a mask such as a photoresist is formed in the wiring region 6a consisting of a polysilicon layer and the CVD oxide film 8 on the upper portion of the gate contact region 6b, and the resultant structure is covered with CVD oxide films 8b and 8c.

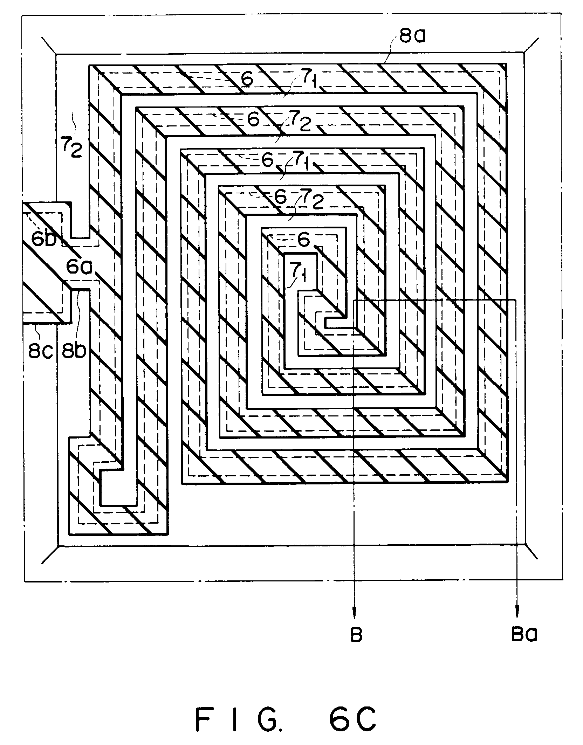

The above steps described in Figs. 3E and 6C may be the same as those shown in Figs. 5E and 6C.

In the plan view shown in Fig. 6C, the CVD oxide films formed on the wiring region 6a and 6b shown in Fig. 5D are represented by reference numerals 8b and 8c.

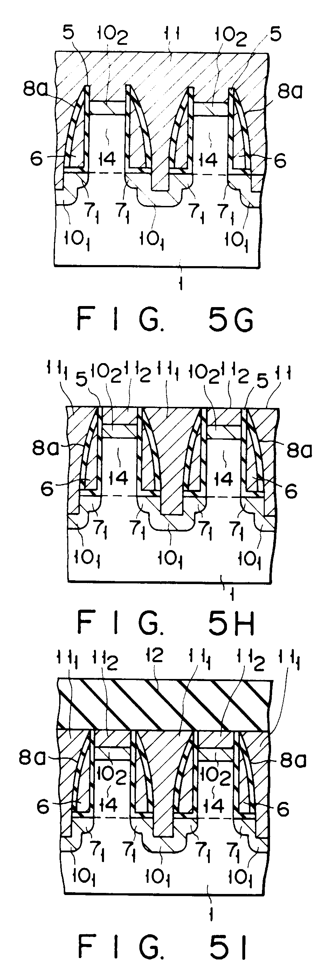

The above steps described in Figs. 3F and 3G may be the same as those shown in Figs. 5F and 5G.

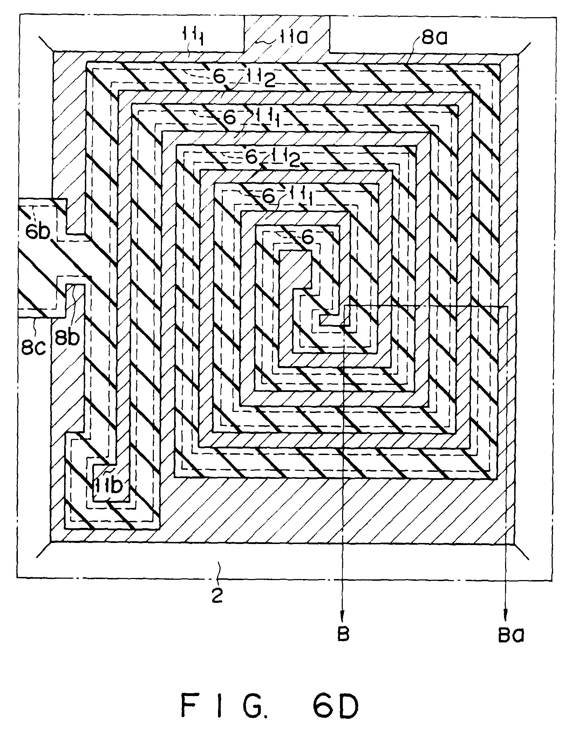

The above steps described in Figs. 3H and 4D may be the same as those shown in Figs. 5H and 6D.

Referring to Fig. 6D, regions represented by reference numerals 11a and 11b are to be contact portions.

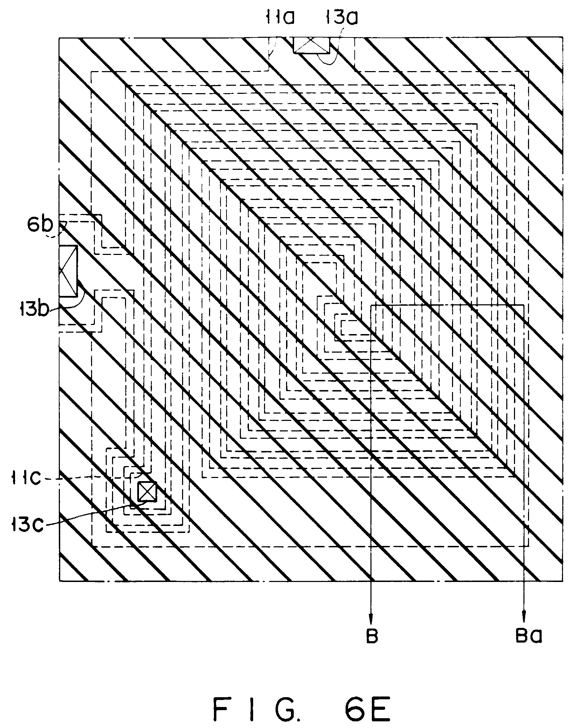

The above steps described in Figs. 3I and 4E may be the same as those in Figs. 5I and 6E.

Contact holes 13a, 13b, and 13c are formed in the contact portions 11a, 6a, and 11b.

With the above steps, a MOS transistor included in the device according to the second embodiment is formed.

As described above, even when a projection region is selectively formed to obtain the cylindrical region 14, the same effect as in the first embodiment can be obtained.

A method of forming a first groove 3 in the second embodiment is different from that in the first embodiment. Although the first groove 3 can be obtained by facing the cylindrical regions 4, the first groove has the same function as that of the first groove 3 described in the first embodiment. Therefore, the same reference numeral as in the first embodiment denotes the same first groove in the second embodiment.

As described above, a spiral-shaped pattern is used as a pattern of the cylindrical region having a curved portion.

A zigzag pattern is represented from various patterns of other cylindrical regions each having a curved portion. The zigzag pattern will be described as the third and fourth embodiments.

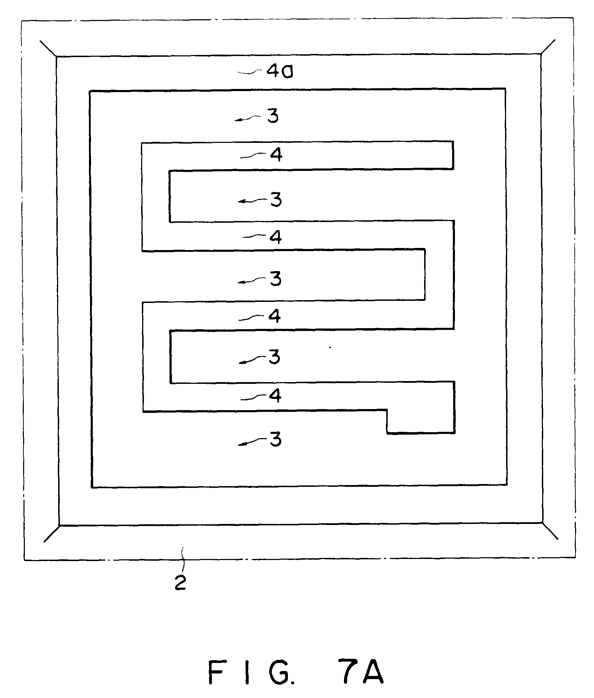

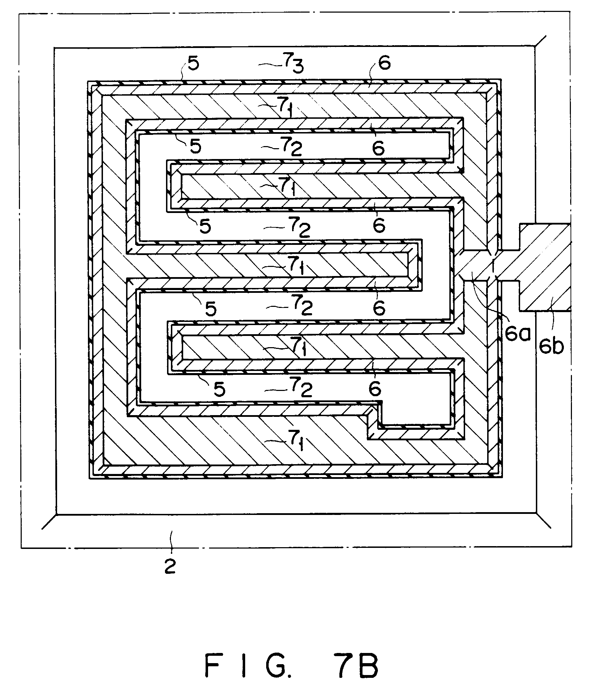

Figs. 7A and 7B are plan views showing a manufacturing step in the third embodiment. The reference numerals in Figs. 7A and 7B denote the same parts as in Figs. 4A and 4E.

As shown in Fig. 7A, a cylindrical region 4 is formed by the same step as in the first embodiment. The cylindrical region 4 has not a spiral shape but a zigzag shape.

In the third embodiment, although the zigzag-shaped cylindrical region 4 is isolated by a groove 3, the cylindrical region 4 may be connected to a flat portion 4a shown in Fig. 7A.

As shown in Fig. 7B, as in the first embodiment, impurity layers $7_1$ to $7_3$ of a conductivity type opposite to that of a substrate 1, a gate insulating film 5, and a gate electrode 6 are formed. As shown in Fig. 7B, a prospective gate contact region 6b and a wiring region 6a extending from the gate electrode to the region 6b are formed by a photoetching method in advance.

Although the sequential manufacturing steps are not especially shown, the same steps as in the first embodiment can be used.

Even if the cylindrical region 4 is formed into a zigzag shape, the same effect as described in the first and second embodiments can be obtained.

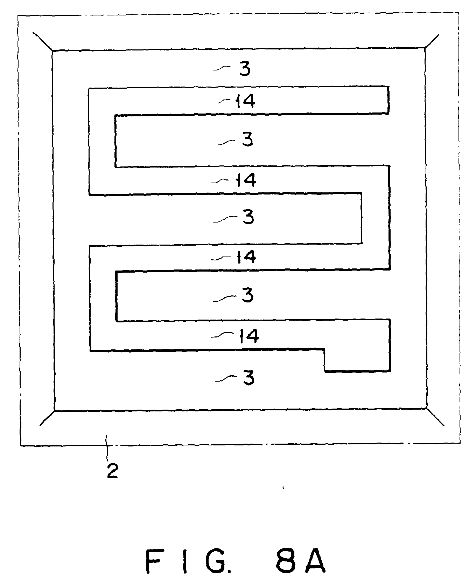

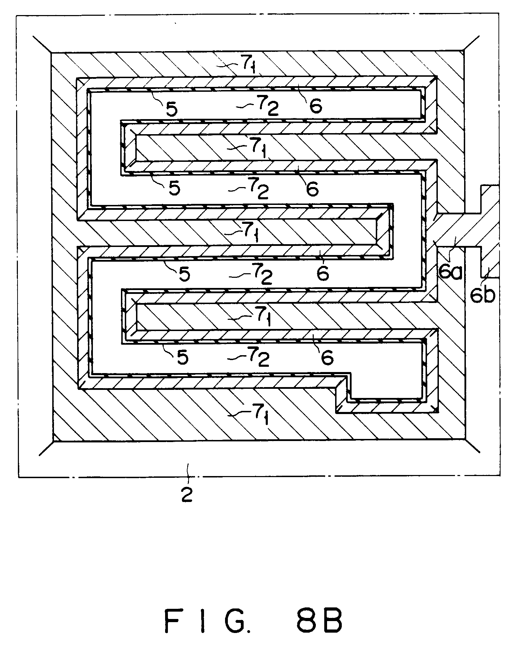

A semiconductor device according to the fourth embodiment will be described below with reference to Figs. 8A and 8B.

Figs 8A and 8B are plan views showing a manufacturing step of the fourth embodiment. The reference numerals in Figs. 8A and 8B denote the same parts as in Fig. 4.

As shown in Fig. 8A, as in the second embodiment, a cylindrical region 14 is formed by an SEG method to have not a spiral shape but a zigzag shape.

As shown in Fig. 8B, impurity layers $7_1$ and $7_2$ of a conductivity type opposite to that of a substrate 1, a gate insulating film 5, and a gate electrode 6 are formed in the same method as described in the second embodiment. As shown in Fig. 8B, prospective gate contact region 6b, and a wiring region 6a extending from the gate electrode 6 to the region 6b are formed by, e.g., a photoetching method in advance.

Although the sequential steps are not especially shown, the same steps as in the second embodiment can be used.

As described above, even when the cylindrical region 14 is formed into a zigzag shape to obtain a curved portion, the same effect as in the first to third embodiments can be obtained.

The field effect transistors included in semiconductor devices according to the first to fourth embodiments have been described using MOS transistors as examples. In these embodiments, high-output MOS transistors could be obtained, and methods of manufacturing the high-output MOS transistors have also been described.

The present invention is not limited to a MOS field effect transistor. Even if other types of field effect transistors are used, the same effect as described above can be obtained. For example, a MES field effect transistor representing a field effect transistor formed on a GaAs substrate may be used.

In this case, a gate insulating film need not be formed. Since the GaAs itself is a semiconductor, an element isolation region represented by a field oxide film is not necessarily formed.

**Claims**

1. A semiconductor device comprising:

   a semiconductor substrate (1) of a first conductivity type;
   a wall-like region (4) formed on a surface of said semiconductor substrate (1)
   a first insulating film (5) which is formed on the side wall of said wall-like region (4) and on a bottom surface of a groove (3) formed by said wall-like region (4) and which projects from the side wall of the wall-like region (4);
   a conductive layer (6) formed on the first insulating film (5);
   a second insulating film (8a) formed on said conductive layer (6);

a first impurity region (71, 101) of a second conductivity type formed at a position below the bottom surface of said groove (3) of said semiconductor substrate (1);

a second impurity region (102) of the second conductivity type formed n a top surface of said wall-like region (4);

first and second metal layers (111, 112), for filling said groove (3) and a portion surrounded by the top surface of said wall-like region (4) and said first insulating film (5); and

a third insulating film (12) for covering said first and second metal layers (111, 112); characterised in that said wall-like region is formed in such a way that it is of an extended single continuous form and has side walls opposing each other at least one portion of it.

2. The semiconductor device according to claim 1 wherein the device is an MOS field effect transistor;

the first insulating film is a gate insulating film (5);

the conductive layer (6) is a gate electrode (6);

the first impurity region is a first source/drain region (71);

and the second impurity region is a second source/drain region (102).

3. The semiconductor device according to claim 1 or 2, characterized in that said wall-like region (4) has in plan view, a spiral shape, with one terminal located at a center of the semiconductor substrate (1) and the other terminal located in a peripheral portion of said semiconductor substrate (1).

4. The semiconductor device according to claim 1 or 2, characterized in that said wall-like region (4) has in plan view, a zigzag shape, with one terminal located at a corner of said semiconductor substrate (1), and the other terminal located at a corner different from the corner where one terminal is located.

5. The semiconductor device according to claim 1 or 2, characterized by further comprising a fourth insulating film (2) and a flat portion (4a) of said semiconductor substrate formed on a peripheral portion of said semiconductor substrate (1) outside an outermost portion of said groove (3).

6. The semiconductor device according to claim 5, characterized in that said wall-like region (4) is isolated from said flat portion (4a) and has an island shape.

7. The semiconductor device according to claim 5, characterized in that said wall-like region (4) is connected to said flat portion (4a).

8. The semiconductor device according to claim 1 or 2, characterized in that said semiconductor substrate (1) is a silicon substrate.

9. The semiconductor device according to claim 1 or 2, characterized in that said first insulating film (5) is a silicon oxide film.

10. The semiconductor device according to claim 1 or 2, characterized in that said conductive layer (6) is a polysilicon layer in which an impurity of the second conductivity type is doped.

11. The semiconductor device according to claim 1 or 2, characterized in that said second insulating film (8) is a CVD oxide film.

12. The semiconductor device according to claim 1 or 2, characterized in that said first and second metal layers (111, 112) are aluminium layers.

13. The semiconductor device according to claim 1, characterized in that said first and second impurity layers (71, 101, 102) are source/drain electrodes of a MOS field effect transistor, and said conductive layer (6) is a gate electrode of the MOS field effect transistor.

14. The semiconductor device according to claim 1 or 2, characterized in that said wall-like region (4) is formed such that an interval $\underline{d}$ between opposite side walls of said wall-like region (4) and a maximum thickness T of said conductive layer (6) in a lateral direction satisfy d > 2T.

15. A method of manufacturing a semiconductor device according to any preceding claim comprising the steps of:

forming a wall-like region (4), side walls of which are opposite to each other at least one portion on a semiconductor substrate (1) of a first conductivity type;

forming a first insulating film (5) on an entire surface;

forming a polysilicon layer (8) on the entire surface;

etching said polysilicon layer (8) to be left on only the side wall of said wall-like region (4);

doping an impurity of a second conductivity type in said semiconductor substrate (1) under a bottom surface of a first groove (3) formed by said wall-like region (4) and in a top surface of said wall-like region (4) through said first insulating film (5) to form first and second impurity regions (71, 72), and said conducting polysilicon layer (8a);

forming a second insulating film (8) on the entire surface;

etching said second insulating film (8) to be left on only said polysilicon layer (8a) and etching said first insulating film (5) to expose said first impurity region (71) under the bottom surface of said first groove (3) and said second impurity region (72) on the top surface of said wall-like region (4);

removing the exposed portion of said first impurity region (71) to a second groove (91) and removing said second impurity region to form a third groove (92);

doping an impurity of the second conductivity type in bottom surfaces of said second and third grooves (91, 92) to form third and fourth impurity regions (101, 102);

activating the impurity of the second conductivity type of said first, third, fourth impurity regions (71, 101, 102);

forming a metal layer (11) on the entire surface; etching said metal layer (11) to be left on only said first, second and third grooves (3, 91, 92); and

forming a third insulating film (12) on the entire surface.

16. The method according to claim 15, characterized in that the step of forming said wall-like region (4) is the step of forming said wall-like region (4) by etching said semiconductor substrate (1) to form said first groove (3).

17. The method according to claim 15, characterized in that the step of etching said polysilicon layer to be left on only the side surface of said wall-like region (4) is the step of anisotropically etching said polysilicon layer to be left from a position above an upper end of said wall-like region (4) by 2,000 Å to the bottom surface of said first groove (3).

**Patentansprüche**

1. Halbleiterbauelement mit:

einem Halbleitersubstrat (1) eines ersten Leitfähigkeitstyps;

einem auf einer Fläche des Halbleitersubstrats (1) ausgebildeten wandartigen Bereich (4);

einer ersten Isolierschicht (5), welche auf der Seitenwand des wandartigen Bereichs (4) und auf einer Bodenfläche einer von dem wandartigen Bereich (4) gebildeten Rille (3) ausgebildet ist und welche von der Seitenwand des wandartigen Bereichs (4) in die Rille (3) hineinragt;

einer auf der ersten Isolierschicht (5) ausgebildeten Leiterschicht (6);

einer auf der Leiterschicht (6) ausgebildeten zweiten Isolierschicht (8a);

einem ersten Dotierungsbereich ($7_1$, $10_1$) eines zweiten Leitfähigkeitstyps, der unter der Bodenfläche der Rille (3) des Halbleitersubstrats (1) ausgebildet ist;

einem zweiten Dotierungsbereich ($10_2$) eines zweiten Leitfähigkeitstyps, der an der Oberseite des wandartigen Bereichs (4) ausgebildet ist;

ersten und zweiten Metallschichten ($11_1$, $11_2$) zum Ausfüllen der Rille (3) sowie eines Bereiches, der von der Oberseite des wandartigen Bereiches (4) und der ersten Isolierschicht (5) begrenzt wird; und

einer dritten Isolierschicht (12) zum Abdecken der ersten und zweiten Metallschicht ($11_1$, $11_2$); dadurch gekennzeichnet, daß der wandartige Bereich derart ausgebildet ist, daß er eine ausgedehnte einteilige Form mit Seitenwänden aufweist, die einander zumindest teilweise gegenüberliegen.

2. Halbleiterbauelement nach Anspruch 1, wobei dieses Bauelement ein MOS-Feldeffekttransistor ist und

die erste Isolierschicht eine Gate-Isolierschicht (5) ist;

die Leiterschicht (6) eine Gate-Elektrode (6) ist;

der erste Dotierungsbereich ein erster Source-Drain-Bereich ($7_1$) ist;

und der zweite Dotierungsbereich ein zweiter Source-Drain-Bereich ($10_2$) ist.

3. Halbleiterbauelement nach Anspruch 1 oder 2, dadurch gekennzeichnet, daß der wandartige Bereich (4) in der Draufsicht eine Spiralform hat, wobei ein Anschluß in der Mitte des Halbleitersubstrates (1) und der andere Anschluß im Randabschnitt des Halbleitersubstrates (1) gelegen ist.

4. Halbleiterbauelement nach Anspruch 1 oder 2, dadurch gekennzeichnet, daß der wandartige Bereich (4) in der Draufsicht eine Zick-Zack-Form hat, wobei ein Anschluß in einer Ecke des Halbleitersubstrats (1) und der andere Anschluß in einer anderen Ecke gelegen ist.

5. Halbleiterbauelement nach Anspruch 1 oder 2, weiter dadurch gekennzeichnet, daß es eine vierte Isolierschicht (2) und einen ebenen Abschnitt (4a) des Halbleitersubstrates aufweist, die im Randabschnitt des Halbleitersubstrates (1) außerhalb des äußeren Abschnittes der Rille (3) ausgebildet sind.

6. Halbleiterbauelement nach Anspruch 5, dadurch gekennzeichnet, daß der wandartige Bereich (4) von dem ebenen Abschnitt (4a) isoliert ist und die Form einer Insel hat.

7. Halbleiterbauelement nach Anspruch 5, dadurch gekennzeichnet, daß der wandartige Bereich (4) mit dem ebenen Abschnitt (4a) verbunden ist.

8. Halbleiterbauelement nach Anspruch 1 oder 2, dadurch gekennzeichnet, daß das Halbleitersubstrat (1) ein Siliziumsubstrat ist.

9. Halbleiterbauelement nach Anspruch 1 oder 2, dadurch gekennzeichnet, daß die erste Isolierschicht (5) eine Siliziumoxidschicht ist.

10. Halbleiterbauelement nach Anspruch 1 oder 2, dadurch gekennzeichnet, daß die Leiterschicht (6) eine Polysiliziumschicht ist, die mit einem Dotanden des zweiten Leitfähigkeitstyps dotiert ist.

11. Halbleiterbauelement nach Anspruch 1 oder 2, dadurch gekennzeichnet, daß die zweite Isolierschicht (8) eine CVD-Oxidschicht ist.

12. Halbleiterbauelement nach Anspruch 1 oder 2, dadurch gekennzeichnet, daß die erste und die zweite Metallschicht ($11_1$, $11_2$) Aluminiumschichten sind.

13. Halbleiterbauelement nach Anspruch 1, dadurch gekennzeichnet, daß die erste und die zweite Dotierungschicht ($7_1$, $10_1$, $10_2$) Source-/Drain-Elektroden eines MOS-Feldeffekttransistors und die Leiterschicht (6) eine Gate-Elektrode des MOS-Feldeffekttransistors sind.

14. Halbleiterbauelement nach Anspruch 1 oder 2, dadurch gekennzeichnet, daß die wandartigen Bereiche (4) derart ausgebildet sind, daß ein Abstand d zwischen einander gegenüberliegenden Seitenwänden des wandartigen Bereichs (4) und eine maximale Dicke T der Leiterschicht (6) in seitlicher Richtung die Beziehung $d > 2T$ erfüllen.

15. Verfahren zur Herstellung eines Halbleiterbauelements nach einem der vorhergehenden Ansprüche mit folgenden Schritten:

Ausbilden eines wandartigen Bereichs (4), dessen Wände einander gegenüber liegen auf mindestens einem Teil eins Halbleitersubstrates (1) eines ersten Leitfähigkeitstyps;

Ausbilden einer Polysiliziumschicht (8) auf der ganzen Oberfläche;

Ätzen der Polysiliziumschicht (8) derart, daß nur die Seitenwand des wandartigen Bereichs (4) verbleibt;

Dotieren des Halbleitersubstrats (1) mit einem Dotanden eines zweiten Leitfähigkeitstyps unter der Bodenfläche einer ersten Rille (3), die vom wandartigen Bereich (4) gebildet wird sowie an der Oberseite des wandartigen Bereichs (4) durch die erste Isolierschicht (5) hindurch, um erste und zweite Dotierungsbereiche ($7_1$, $7_2$) und die leitfähige Polysiliziumschicht (8a) auszubilden;

Ausbilden einer zweiten Isolierschicht (8) auf der ganzen Oberfläche;

Ätzen der zweiten Isolierschicht (8) derart, daß sie nur auf der Polysiliziumschicht (8a) verbleibt, sowie Ätzen der ersten Isolierschicht (5), um den ersten Dotierungsbereich ($7_1$) unter dem Boden der ersten Rille (3) und den zweiten Dotierungsbereich ($7_2$) an der Oberseite des wandartigen Bereiches (4) freizulegen;

Entfernen des freigelegten Teils des ersten Dotierungsbereiches ($7_1$), um eine zweite Rille ($9_1$) auszubilden, und Entfernen des zweiten Dotierungsbereiches, um eine dritte Rille ($9_2$) auszubilden;

Dotieren von Dotanden des zweiten Leitfähigkeitstyps in die Bodenflächen der zweiten und dritten Rillen ($9_1$, $9_2$), um dritte und vierte Dotierungsbereiche (101, 102) auszubilden;

Aktivieren des Dotanden des zweiten Leitfähigkeitstyps des ersten, dritten und vierten Dotierungsbereiches ($7_1$, $10_1$, $10_2$);

Ausbilden einer Metallschicht (11) auf der ganzen Oberfläche;

Ätzen der Metallschicht (11) derart, daß sie nur in der ersten, zweiten und dritten Rille (3, $9_1$, $9_2$) verbleibt; und

Ausbilden einer dritten Isolierschicht (12) auf der ganzen Oberfläche.

16. Verfahren nach Anspruch 15, dadurch gekennzeichnet, daß der Schritt der Ausbildung des wandartigen Bereiches (4) ein Schritt zur Ausbildung desselben durch Ätzen des Halbleitersubstrates (1) ist, um die erste Rille (3) zu erzeugen.

17. Verfahren nach Anspruch 15, dadurch gekennzeichnet, daß der Schritt zum Ätzen der Polysiliziumschicht, damit sie nur auf der Seitenfläche des wandartigen Bereichs (4) verbleibt, im anisotropen Ätzen der Polysiliziumschicht besteht derart, daß sie nur in einem Bereich verbleibt, der von einem Abstand von 2.000 Å vom oberen Ende des wandartigen Bereiches (4) bis zur Bodenfläche der ersten Rille (3) reicht.

**Revendications**

1. Dispositif à semiconducteur comprenant :

un substrat semiconducteur (1) d'un premier type de conductivité ;
une région en forme de paroi (4) formée sur une surface dudit substrat semiconducteur (1) ;
un premier film isolant (5) qui est formé sur la paroi latérale de ladite région en forme de paroi (4) et sur une surface de fond d'une gorge (3) formée par ladite région en forme de paroi (4) et qui fait saillie depuis la paroi latérale de la région en forme de paroi (4) ;
une couche conductrice (6) formée sur le premier film isolant (5) ;
un second film isolant (8a) formé sur ladite couche conductrice (6) ;
une première région d'impuretés $(7_1, 10_1)$ d'un second type de conductivité formée en une position au-dessous de la surface de fond de ladite gorge (3) dudit substrat semiconducteur (1) ;
une seconde région d'impuretés $(10_2)$ du second type de conductivité formée sur une surface de sommet de ladite région en forme de paroi (4) ;
des première et seconde couches métalliques $(11_1, 11_2)$ pour remplir ladite gorge (3) et une partie entourée par la surface de sommet de ladite région en forme de paroi (4) et par ledit premier film isolant (5); et
un troisième film isolant (12) pour recouvrir lesdites première et seconde couches métalliques $(11_1, 11_2)$,
caractérisé en ce que ladite région en forme de paroi est formée de telle façon qu'elle soit selon une unique forme continue étendue et qu'elle comporte des parois latérales se faisant face l'une l'autre au niveau d'au moins une partie d'elle-même.

2. Dispositif à semiconducteur selon la revendication 1, dans lequel le dispositif est un transistor à effet de champ métal-oxyde-semiconducteur (MOSFET) ;

le premier film isolant est un film d'isolation de grille (5) ;
la couche conductrice (6) est une électrode de grille (6) ;
la première région d'impuretés est une première région de source/drain (71) ; et
la seconde région d'impuretés est une seconde région de source/drain $(10_2)$.

3. Dispositif à semiconducteur selon la revendication 1 ou 2, caractérisé en ce que ladite région en forme de paroi (4) présente, selon une vue en plan, une forme de spirale, une borne étant située au niveau d'un centre du substrat semiconducteur (1) et l'autre borne étant située dans une partie périphérique dudit substrat semiconducteur (1).

4. Dispositif à semiconducteur selon la revendication 1 ou 2, caractérisé en ce que ladite région en forme de paroi (4) présente, selon une vue en plan, une forme de zigzag, une borne étant située au niveau d'un angle dudit substrat semiconducteur (1) et l'autre borne étant située au niveau d'un angle différent de l'angle où la première borne est située.

5. Dispositif à semiconducteur selon la revendication 1 ou 2, caractérisé en ce qu'il comprend en outre un quatrième film isolant (2) et une partie plane (4a) dudit substrat semiconducteur formée sur une partie périphérique dudit substrat semiconducteur (1) à l'extérieur d'une partie la plus externe de ladite gorge (3).

6. Dispositif à semiconducteur selon la revendication 5, caractérisé en ce que ladite région en forme de paroi (4) est isolée de ladite partie plane (4a) et présente une forme d'îlot.

7. Dispositif à semiconducteur selon la revendication 5, caractérisé en ce que ladite région en forme de paroi (4) est connectée à ladite partie plane (4a).

8. Dispositif à semiconducteur selon la revendication 1 ou 2, caractérisé en ce que ledit substrat semiconducteur (1) est un substrat en silicium.

9. Dispositif à semiconducteur selon la revendication 1 ou 2, caractérisé en ce que ledit premier film isolant (5) est un film d'oxyde de silicium.

**10.** Dispositif à semiconducteur selon la revendication 1 ou 2, caractérisé en ce que ladite couche conductrice (6) est une couche en polysilicium dans laquelle une impureté du second type de conductivité est dopée.

**11.** Dispositif à semiconducteur selon la revendication 1 ou 2, caractérisé en ce que ledit second film isolant (8) est un film d'oxyde déposé par dépôt chimique en phase vapeur (CVD).

**12.** Dispositif à semiconducteur selon la revendication 1 ou 2, caractérisé en ce que lesdites première et seconde couches métalliques ($11_1$, $11_2$) sont des couches d'aluminium.

**13.** Dispositif à semiconducteur selon la revendication 1, caractérisé en ce que lesdites première et seconde couches d'impuretés ($71$, $10_1$, $10_2$) sont des électrodes de source/drain d'un transistor à effet de champ métal-oxyde-semiconducteur (MOSFET) et ladite couche conductrice (6) est une électrode de grille du transistor MOSFET.

**14.** Dispositif à semiconducteur selon la revendication 1 ou 2, caractérisé en ce que ladite région en forme de paroi (4) est formée de telle sorte qu'un intervalle $\underline{d}$ entre des parois latérales opposées de ladite région en forme de paroi (4) et une épaisseur maximum T de ladite couche conductrice (6) suivant une direction latérale satisfassent $d > 2T$.

**15.** Procédé de fabrication d'un dispositif à semiconducteur selon l'une quelconque des revendications précédentes, comprenant les étapes de :

formation d'une région en forme de paroi (4) dont des parois latérales sont opposées l'une à l'autre au niveau d'au moins une partie sur un substrat semiconducteur (1) d'un premier type de conductivité ;
formation d'un premier film isolant (5) sur la totalité de la surface ;
formation d'une couche de polysilicium (8) sur la totalité de la surface ;
gravure de ladite couche de polysilicium (8) de telle sorte qu'elle soit laissée sur seulement la paroi latérale de ladite région en forme de paroi (4);
dopage d'une impureté d'un second type de conductivité dans ledit substrat semiconducteur (1) sous une surface de fond d'une première gorge (3) formée par ladite région en forme de paroi (4) et dans une surface de sommet de ladite région en forme de paroi (4) au travers dudit premier film isolant (5) afin de former des première et seconde régions d'impuretés ($7_1$, $7_2$), et réalisation de la conduction de ladite couche de polysilicium (8a) ;
formation d'un second film isolant (8) sur la totalité de la surface ;
gravure dudit second film isolant (8) de telle sorte qu'il soit laissé sur seulement ladite couche en polysilicium (8a) et gravure dudit premier film isolant (5) afin de mettre à nu ladite première région d'impuretés ($7_1$) sous la surface de fond de ladite première gorge (3) et ladite seconde région d'impuretés ($7_2$) sur la surface de sommet de ladite région en forme de paroi (4) ;
enlèvement de la partie mise à nu de ladite première région d'impuretés ($7_1$) selon une seconde gorge ($9_1$) et enlèvement de ladite seconde région d'impuretés pour former une troisième gorge ($9_2$) ;
dopage d'une impureté du second type de conductivité dans des surfaces de fond desdites seconde et troisième gorges ($91$, $9_2$) afin de former des troisième et quatrième régions d'impuretés ($10_1$, $10_2$) ;
activation de l'impureté du second type de conductivité desdites première, troisième, quatrième régions d'impuretés ($7_1$, $10_1$, $10_2$) ;
formation d'une couche métallique (11) sur la totalité de la surface ;
gravure de ladite couche métallique (11) de telle sorte qu'elle soit laissée sur seulement lesdites première, seconde et troisième gorges (3, $9_1$, $9_2$) ; et
formation d'un troisième film isolant (12) sur la totalité de la surface.

**16.** Procédé selon la revendication 15, caractérisé en ce que l'étape de formation de ladite région en forme de paroi (4) est l'étape de formation de ladite région en forme de paroi (4) en gravant ledit substrat semiconducteur (1) afin de former ladite première gorge (3).

**17.** Procédé selon la revendication 15, caractérisé en ce que l'étape de gravure de ladite couche de polysilicium pour qu'elle soit laissée sur seulement la surface latérale de ladite région en forme de paroi (4) est l'étape de gravure anisotrope de ladite couche de polysilicium de telle sorte qu'elle soit laissée depuis une position au-dessus d'une extrémité supérieure de ladite région en forme de paroi (4) sur 2000 Å jusqu'à la surface de fond de ladite première gorge (3).

F I G. 1

F I G. 2

EP 0 439 164 B1

F I G.   3A

F I G.   3D

F I G.   3B

F I G.   3E

F I G.   3C

F I G.   3F

F I G. 3G

F I G. 3H

F I G. 3I

F I G. 4A

FIG. 4B

FIG. 4C

F I G. 4D

F I G. 4E

F I G. 5A

F I G. 5D

F I G. 5B

F I G. 5E

F I G. 5C

F I G. 5F

F I G. 5G

F I G. 5H

F I G. 5 I

F I G. 6A

F I G. 6B

F I G. 6C

F I G. 6D

F I G. 6E

F I G. 7A

F I G. 7B

F I G.   8 A

F I G. 8B